# EUROPEAN PATENT APPLICATION

(11) **EP 3 996 156 A1**
(43) Date of publication of application: **11.05.2022**
(21) Application number: 20889983.1
(22) Date of filing: 07.01.2020
(51) Int. Cl.: H01L 33/48, F21S 4/24, H01L 25/075

(54) **LED LIGHT STRIP SUBSTRATE, LED LIGHT STRIP AND TERMINAL DEVICE**

(30) Priority: 18.11.2019 CN 201911125257; 18.11.2019 CN 201921987307 U
(71) Applicant: Shenzhen Singsun Technology Co., Ltd., Shenzhen, Guangdong 518000 (CN)
(72) Inventor: PENG, Shengqin, Shenzhen, Guangdong 518000 (CN); ZHONG, Yun, Shenzhen, Guangdong 518000 (CN)
(74) Representative: Deambrogi, Edgardo
(86) International application number: PCT/CN2020/070764
(87) International publication number: WO 2021/098031

(57) **Abstract**

An LED light strip substrate, an LED light strip and a terminal device. The LED light strip substrate comprises: a body region (110) and peninsula regions (120); the peninsula regions (120) are spaced apart along the edge of the body region (110) and can bend so as to form a predetermined angle (θ) with the body region (110), the peninsula regions are configured into an LED flip chip (150); and the body region (110) is provided with a circuit used for connecting the LED flip chip (150). The LED light strip substrate can effectively enable the light emitted by the LED flip chip (150) to be issued from the sides of the LED light strip substrate. With regards to forming an LED side light-emitting light strip, the structure of such an LED light strip substrate is simple and easy to implement, which is obviously advantageous for the universal application of the LED side light-emitting light strip.

## Description

### Cross-references to related applications

The present disclosure claims the priority of the Chinese patent application filed with the Chinese Patent Office on November 18, 2019, with the application number of CN201911125257.9, entitled as "LED light strip substrate, LED light strip and terminal device", and the priority of the Chinese patent application filed with the Chinese Patent Office on November 18, 2019, with the application number of CN201921987307.X, entitled as "LED side light-emitting light strip and terminal device ", the entire contents of which are incorporated into the present disclosure by reference.

### Technical Field

The present disclosure relates to the technical field of electronic appliances, in particular to an LED light strip substrate, an LED light strip and a terminal device.

### Background Art

In the prior art, due to the limitation of the light strip substrate itself, the common side light-emitting light strips mainly comprise the following types: a side light-emitting light strip, that uses a LED patch lamp bead as the light source; a side light-emitting light strip, which is formed by making a conventional light strip wrapped in a silicone sleeve; or a side light-emitting light strip, which is formed in a way that the optical lens are made to cover the patch lamp beads of the conventional LED light strip and the light output angle of the lamp beads is changed through the optical lens, and the packaging is performed. These side light-emitting light strips in the prior art have the defects of large volume and low luminous efficiency.

### Summary

In view of this, the objectives of the exemplary embodiments of the present disclosure comprise, for example, providing an improved LED light strip substrate, LED light strip, and terminal device, to overcome the defects of the large volume and low luminous efficiency of the LED side light-emitting light strip in the prior art.

In order to achieve the foregoing objectives, the exemplary embodiments of the present disclosure provide the following technical solutions.

Exemplary embodiments of the present disclosure provide an LED light strip substrate, comprising a body region and peninsula regions. The peninsula regions are spaced apart along an edge of the body region and the peninsula regions can be bent to form a predetermined angle with the body region, and the peninsula regions are each configured to be provided with an LED flip chip; and the body region is provided with a circuit configured to connect the LED flip chips.

Optionally, each of the peninsula regions comprises a chip placement region and a bending region arranged between the body region and the chip placement region; the chip placement region is configured to be provided with the LED flip chip; and a width of the bending region is smaller than that of the chip placement region.

Optionally, a width of the bending region, which is at a first section whose width is narrowest in a lateral direction, is smaller than a width of the chip placement region, which is at a second section whose width is narrowest in the lateral direction. In short, the narrowest width of the bending region in the lateral direction is smaller than the narrowest width of the chip placement region in the lateral direction.

Optionally, a shape formed by an edge or part of the edge between two adjacent bending regions is a circular arc shape.

Optionally, in the chip placement region, two sides configured to allow placement of the LED flip chips are each provided with a light-shielding reflection part configured for adjusting a light output angle of the LED flip chip; and an extension direction of the light-shielding reflection parts is perpendicular to an extension direction of the chip placement region.

Optionally, the predetermined angle is an angle of an included angle between the peninsula regions and the body region, and the predetermined angle is greater than 0 degrees and less than 180 degrees; and at the side of the included angle, that is, between a side of the body region related to the included angle and a side of each of the peninsula regions related to the included angle, a filling shaping part is provided for supporting and fixing the peninsula region and the body region; and the filling shaping part is located on a side opposite to a surface side where the LED flip chip is provided.

Optionally, spacing between individual peninsula regions may be 1mm-5mm, e.g., optionally, it may be 1.8mm-2.5mm, and a length is 1.5mm-5mm.

Exemplary embodiments of the present disclosure also provide an LED light strip, comprising the LED light strip substrate and LED flip chips provided on the peninsula regions.

Optionally, fluorescent glue is wrapped on each of the LED flip chips.

Exemplary embodiments of the present disclosure provide a terminal device, comprising the LED light strip mentioned above.

Optionally, the terminal device comprises a light box.

The LED light strip substrate provided by the exemplary embodiments of the present disclosure helps to realize an LED side light-emitting light strip with the overall volume small and the cost low, which is suitable for the terminal devices with a small internal installation structure space and a bending region. The LED light strip provided by the exemplary embodiments of the present disclosure can effectively cause the light emitted by the LED flip chip to be emitted from the sides of the LED light strip substrate, and the structure of the LED side light-emitting light strip constructed in such a way is simple and easy to implement. In addition, the LED light strips provided by the exemplary embodiments of the present disclosure are particularly convenient to be bent and mounted in the gap of the terminal device, and are not easy to be broken and at the same time help to achieve a more continuous side light-emitting effect, to meet the light-emitting requirements of the terminal devices and improve the lighting display effect of the terminal devices.

Exemplary embodiments of the present disclosure also provide another LED side light-emitting light strip, which includes a substrate, a first surrounding dam provided on the substrate, and a plurality of LED flip chips. Each LED flip chip is arranged at a position at a predetermined distance from the edge of a substrate; and compared with the LED flip chip, the first surrounding dam is arranged at a position closer to the inner side of the substrate.

Optionally, the edge of the substrate is located on the outer side of the substrate, opposite to the inner side of the substrate; or, the inner side of the substrate is the side of the LED substrate where no LED flip chip is provided.

Optionally, the another LED side light-emitting light strip further includes a fluorescent glue wrapping the LED flip chip.

Optionally, the another LED side light-emitting light strip further includes a second surrounding dam. The second surrounding dam may be at least partially arranged above the fluorescent glue. As an example, the second surrounding dam may be partly arranged on the fluorescent glue and partly arranged on the first surrounding dam, that is, the side or at least part of the side of the second surrounding dam away from the edge of the substrate is connected to the first surrounding dam.

Optionally, the side of the second surrounding dam close to the edge of the substrate extends to a position flush with the edge of the substrate.

Optionally, a thickness of the LED side light-emitting light strip is 1 mm-5mm, and particularly 1mm-3mm.

Optionally, spacing between individual LED flip chips is 1mm-5mm, and particularly 1.5mm-2.2mm.

Optionally, the substrate is a flexible substrate.

Optionally, the fluorescent glue is continuously provided on the substrate and covers each LED flip chip.

Exemplary embodiments of the present disclosure also provide another terminal device, such as a light box, which includes the above-mentioned another LED side light-emitting light strip.

Compared with the existing LED side light-emitting light strip, the another LED side light-emitting light strip provided by the exemplary embodiments of the present disclosure can effectively enables the light output direction of the LED flip chip to extend from the side of the substrate, which plays a role of limiting the light output angle of the LED flip chip, preventing the light emitted from it from spreading too much. In addition, the overall another LED side light-emitting light strip provided by the exemplary embodiments of the present disclosure is lighter and thinner in volume, and the cost is lower, which can meet the requirements which the terminal devices with a relatively small internal installation space request for the light source.

In addition, said another LED side light-emitting light strip described above may be installed in a terminal device, such as a light box, provided by an exemplary embodiment of the present disclosure, to be used as a light source. The LED side light-emitting light strip can be installed to the side inside the device, or be installed in the gap, or exist in a bent installation structure, to provide a light source for the screen. The terminal device obtains an improved light transmittance rate due to the use of such LED light strips, thereby achieving a better display effect, and obtaining the improved device integration, thereby achieving a thinner and lighter body.

### Brief Description of Drawings

Fig. 1 shows a front view of an LED light strip substrate provided by an embodiment of the present disclosure;
Fig. 2 shows a side view of the LED light strip substrate provided by an embodiment of the present disclosure, after bending;
Fig. 3 shows another front view of the LED light strip substrate provided by the embodiment of the present disclosure;
Fig. 4A and Fig. 4B show another side view of the LED light strip substrate provided by the embodiment of the present disclosure, after bending;
Figs. 5A, 5B, and 5C show another side view of the LED light strip substrate provided by the embodiment of the present disclosure, after bending;
Fig. 6 shows a schematic diagram of an LED light strip provided by an embodiment of the present disclosure;
Fig. 7 shows a first structural schematic diagram of another LED side light-emitting light strip provided by an embodiment of the present disclosure;
Fig. 8 shows a second structural schematic diagram of another LED side light-emitting light strip provided by an embodiment of the present disclosure;
Fig. 9 shows a third structural schematic diagram of another LED side light-emitting light strip provided by an embodiment of the present disclosure;
Fig. 10 shows a fourth structural schematic diagram of another LED side light-emitting light strip provided by an embodiment of the present disclosure;
Fig. 11 shows a fifth structural schematic diagram of another LED side light-emitting light strip provided by an embodiment of the present disclosure; and
Fig. 12 shows a structural schematic diagram of a side light-emitting light strip in the prior art.

### Detailed Description of Embodiments

Hereinafter, various embodiments of the present disclosure will be described more completely. The present disclosure may have various embodiments, which may be subject to adjustments and changes. However, it should be understood that it is not intended to limit the scope of protection of the present disclosure to the embodiments disclosed herein, but the present disclosure should be understood as covering all adjustments, equivalents, and and/or alternatives that fall within the spirit and scope of the various embodiments of the present disclosure.

Hereinafter, the terms, "including" or "may comprise", that can be used in various embodiments of the present disclosure indicate the existence of the disclosed functions, operations, or elements, and do not exclude the addition of one or more functions, operations, or elements. In addition, as used in various embodiments of the present disclosure, the terms, "including", "having" and their cognates, are only intended to represent specific features, numbers, steps, operations, elements, components, or combinations of the foregoing, and should not be understood as first excluding the possibility of the existence of one or more other features, numbers, steps, operations, elements, components or combinations of the foregoing or the addition of one or more features, numbers, steps, operations, elements, components or a combination of the foregoing.

In various embodiments of the present disclosure, the expression, "at least one of A or/and B", comprises any combination or all combinations of the words listed at the same time. For example, the expression "A or B" or "at least one of A or/and B" may comprise A, may comprise B, or may comprise both A and B.

Expressions (such as "first", "second", etc.) used in various embodiments of the present disclosure may indicate various components in the various embodiments, but may not limit the corresponding components. For example, the above expression does not limit the order and/or importance of the elements. The above expressions are only used for the purpose of distinguishing one element from other elements. For example, the first user device and the second user device indicate different user devices, although both are user devices. For example, without departing from the scope of various embodiments of the present disclosure, the first element may be referred to as the second element, and similarly, the second element may also be referred to as the first element.

It should be noted that if it is described that one component is "connected" to another component, the first component can be directly connected to the second component, and the third component can be "connected" between the first component and the second component. On the contrary, when one component is "directly connected" to another component, it can be understood that there is no third component between the first component and the second component.

The terms used in the various embodiments of the present disclosure are only used for the purpose of describing embodiments, which is not intended to limit the various embodiments of the present disclosure. Unless otherwise defined, all terms (including the technical terms and scientific terms) used herein have the same meanings as commonly understood by those skilled in the art to which various embodiments of the present disclosure belong. Terms (such as those defined in commonly used dictionaries) will be interpreted as having the same meaning as the contextual meaning in the relevant technical field and will not be interpreted as having idealized meanings or overly formal meanings, unless it is clearly defined in various embodiments of the present disclosure.

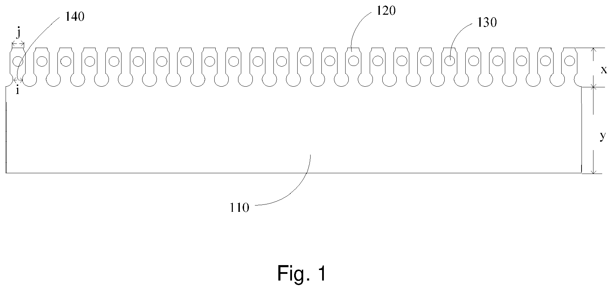

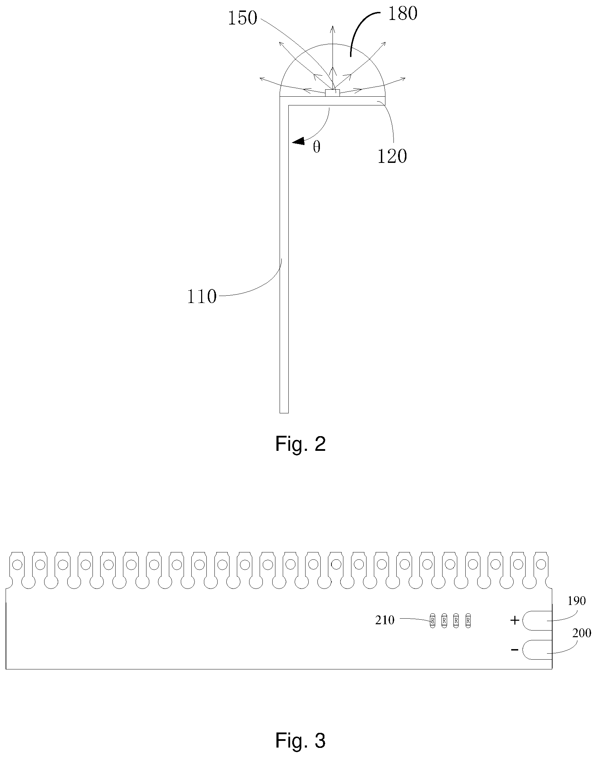

Referring to Figs. 1 and 2, an embodiment of the present disclosure provides an LED light strip substrate, which comprises a body region 110 and peninsula regions 120. The peninsula regions 120 may be spaced apart along at least one edge of the body region 110, such as a lateral edge shown in Fig. 1, and each peninsula region 120 may be bent to form a predetermined angle with the body region 110. The peninsula region 120 can be used to be provided with the LED flip chip. The body region 110 may be provided with a circuit for connecting the LED flip chips.

The body region 110 may be one substrate surface on the LED light strip substrate, where a circuit connected with the LED flip chip is provided. The peninsula regions 120 may be small substrate surfaces spaced apart along the edge of the body region 110 and used for being provided with LED flip chips. The length x of the peninsula region 120 in the longitudinal direction is generally smaller than the length y of the body region 110 in the longitudinal direction, as shown in Fig. 1, for example, the length of the peninsula region can be about 1.5mm-3mm, roughly accounting for 1/8-1/3 of the length y of the body region 110.

In the embodiment of the present disclosure, the peninsula region 120 can be bent such that the peninsula region and the body region 110 form a predetermined angle θ, as shown in Fig. 2, such that when the LED flip chip 150 is provided at the peninsula region 120 on the LED light strip substrate, the light of the LED flip chip 150 can be emitted from the lateral direction of the LED light strip substrate to form the side emitted light and the light of the LED flip chip 150 can be prevented from diverging upward relative to the front surface of the body region 110.

In the embodiment of the present disclosure, the peninsula regions 120 may be arranged at equal intervals or unequal intervals along the edge of the body region 110, preferably at equal intervals. For example, the spacing between adjacent peninsula regions 120 may be 1mm-5mm, and further optionally 1.8mm-2.5mm.

In the LED light strip substrate provided by the embodiment of the present disclosure, the circuit for connecting the LED flip chips comprises the positive electrode190 and the negative electrode200 of the power supply connected to the flip LED chips, as shown in Fig. 3. For example, the voltage of the power supply may be 24V. Optionally, the circuit may also comprise a current limiting resistor 210.

The LED light strip substrate provided by the embodiment of the present disclosure is beneficial to the forming of a side light-emitting LED light strip. For example, when a light strip based on the LED light strip substrate is embedded in a terminal device, it is possible to avoid adding additional devices for guiding the light emitted by the LED to be emitted from the sides of the substrate, which makes the design of the light strip simplified and therefore thinner and lighter, thereby reducing the manufacturing cost and the operating cost.

In addition, the conventional light strip substrate is not easy to be bent and curled, which is caused by the edge side being flat, and when it must be bent and curled, such a light strip substrate will have edges and corners and be easy to be broken, which is not conducive to the installation in the terminal devices with a small space or bend portion. Compared with this, because of the peninsula regions 120 being provided at intervals on the edge of the body region 110, that is, a gap existing between adjacent peninsula regions 120, the LED light strip substrate provided by the embodiment of the present disclosure allows that when being bent and curled, it can form a certain arc, for example, it can be curled into an arc or a circle, which can ensure that the edges remain smooth after the bending and curling and are not easy to be broken.

That is to say, the LED light strip substrate provided by the embodiment of the present disclosure can effectively make the light emitted by the LED flip chip diverge from the sides of the LED light strip substrate, that is, emitted in the lateral direction of the substrate; and the LED light strip substrate provided in the embodiment of the present disclosure helps to realize the LED side light-emitting light strip which is overall light and thin, and of low-cost, and is suitable for terminal devices with small internal installation structure space and a bending region; and in addition, the LED light strip substrate provided by the embodiment of the present disclosure is easy to be bent to be embedded in the gap of the terminal device, is not easy to be broken by bending, and is conducive to achieving a more continuous side light-emitting effect, so as to meet the different lighting needs of the terminal devices and improve the lighting display effect of the terminal devices.

Referring again to Fig. 1, in an embodiment of the present disclosure, the peninsula region 120 may comprise a chip placement region 130 and a bending region 140 disposed between the body region 110 and the chip placement region 130. The chip placement region 130 can be used to be provided with LED flip chips. The lateral width i of the bending region 140 may be smaller than the lateral width j of the chip placement region 130, as shown in Fig. 1. Optionally, the width i corresponds to the width at the section with the narrowest width in the lateral direction of the bending region, and the width j corresponds to the width at the section with the narrowest width in the lateral direction of the chip placement region.

In the LED light strip substrate provided by the embodiment of the present disclosure, the width i of the bending region 140 is designed to be smaller than the width j of the chip placement region 130, so that the peninsula region is convenient for being bent and shaped, thereby effectively realizing the side light-emitting LED light strip. And when the side light-emitting LED light strip of the LED light strip substrate based on this embodiment is embedded in the terminal device, additional devices for guiding light to the lateral direction of the substrate can be omitted, making the light strip lighter and thinner and reducing the cost.

In the embodiment of the present disclosure, the shape formed by the edge or part of the edge between the adjacent bending regions 140 may be an arc shape or a circular arc shape.

In the LED light strip substrate provided by the embodiment of the present disclosure, the shape of the edge between the adjacent bending regions 140 is preferably a circular arc shape, so that the peninsula region 120 is bent to form a predetermined angle with the body region 110. At the same time, such a bending region is not easy to be broken when being bent, so that the edge after bending is smooth.

The LED light strip substrate of the embodiment of the present disclosure can form a side light-emitting LED light strip by providing an LED flip chip on the peninsula region 120. The structure of such an LED light strip is thin, simple, and easy to implement. The LED light strip of the LED light strip substrate based on the embodiment of the present disclosure can be installed in a terminal device with a relatively small internal space, such as in a gap. The LED light strip provided by the embodiment of the present disclosure alleviates the limitation caused by the internal installation structure, and can meet the different lighting requirements of most terminal devices.

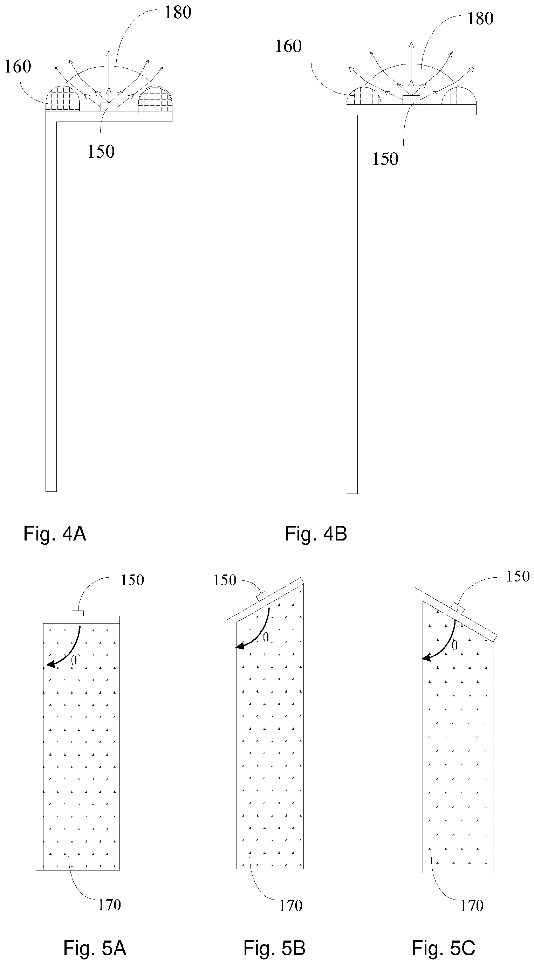

Referring to Figs. 4A, 4B, and 1, in an embodiment of the present disclosure, one or more light-shielding reflection parts 160 may be provided in the chip placement region 130, on two sides for placement of the LED flip chips 150, to adjust the light output angle of the LED flip chips 150. The extending direction of the light-shielding reflection parts 160 may be perpendicular to the extending direction of the chip placement region 130, so that the light-shielding reflection parts 160 can be continuously arranged in the chip placement region 130 to prevent the LED flip chip 150 from leaking light, thereby improving the light output rate of the side light-emitting LED light strip, wherein the extending direction of the chip placement region 130 is the direction in which the peninsula regions 120 protrude from the body region 110 as a whole.

The light-shielding reflection part 160 may be a structure made of light-shielding and reflective materials, such as surrounding dam glue, which can be used to limit the light output angle of the LED flip chip 150. The height of the light-shielding reflection part 160 may be larger than the height of the LED flip chip 150, and the desired light output angle and light-concentrating effect may be obtained by adjusting the height and shape of the light-shielding reflection part 160.

As an example, it can be seen that the height of the light-shielding reflection part 160 shown in Fig. 4B is smaller than the height of the light-shielding reflection part 160 shown in Fig. 4A. If it is assumed that the light output angle of the LED flip chip 150 in Fig. 4B is about 120°, the light output angle of the LED flip chip 150 in Fig. 4A is smaller than the light output angle of Fig. 4B, for example, about 90°.

In the LED light strip substrate provided by the embodiment of the present disclosure, at least one light-shielding reflection part 160 is provided in the chip placement region 130, on the circumferential side of the portion where the LED flip chip 150 is placed, so as to play a role of limiting the light output angle of the LED flip chip, thereby producing a significant positive effect on the light output rate of the side light-emitting LED light strip in the embodiment of the present disclosure.

Referring to Fig. 1 and referring to Fig. 5A, Fig. 5B, and Fig. 5C, in an embodiment of the present disclosure, the predetermined angle θ is the angle of the included angle between the peninsula region 120 and the body region 110.

In the LED light strip substrate provided by the embodiment of the present disclosure, the predetermined angle θ can be any angle, greater than 0 degree and less than 180 degrees, formed by bending according to actual requirements, to achieve the desired side light-emitting effect of the light strip. Typically, the preset angle θ is preferably 60 to 120 degrees, more preferably 80 to 110 degrees, and can usually be set to 90 degrees.

In the embodiment of the present disclosure, a filling shaping part 170 may be provided between the side of the body region 110 related to the included angle θ and the side of the bent peninsula region 120 related to the included angle θ, as shown in Figs. 5A to 5C, to support and fix the peninsula region 120 and the body region 110. The filling shaping part 170 may be provided on the side of the peninsula region 120 opposite to the surface side where the LED flip chip 150 is mounted, to enable a shaping effect on the LED light strip substrate. The filling shaping part 170 may be obtained by being filled and shaped using a silicone sleeve or other materials.

In the embodiment of the present disclosure, the spacing between adjacent peninsula regions may be 1.8mm-2.5mm, but is not limited to this. For example, in some embodiments, the spacing between adjacent peninsula regions may be in a larger range, such as 1mm-5mm, and the length can be 1.5mm-5mm.

As for the LED light strip substrate provided by the embodiments of the present disclosure, the length of each peninsula region should not be too long, and the spacing between the individual peninsula regions should not be too wide, because being too long or too wide will easily cause that corners will appear at edges when being bent and curled and in turn, the substrate is caused to be easily broken. Therefore, the spacing between the peninsula regions can be 1.8mm-2.5mm, such as 1.8mm, 2mm or 2.5mm, preferably 2mm, and the length can be 1.5mm, 2mm, 3mm, 4mm or 5mm, and more preferably 3mm.

The LED light strip substrate provided by the embodiment of the present disclosure is easy to be bent and curled, and when the side light-emitting light strip formed by it is installed in the curved gap of the terminal device, it can be ensured that there is enough area to allow the light of the LED flip chip to pass to the terminal device, such that it can also achieve continuous side light-emitting effect while meeting the light output rate, which meets the light-emitting requirements for different shapes of the devices. Further, the LED light strip substrate provided by the embodiments of the present disclosure is light and small in volume and low in cost.

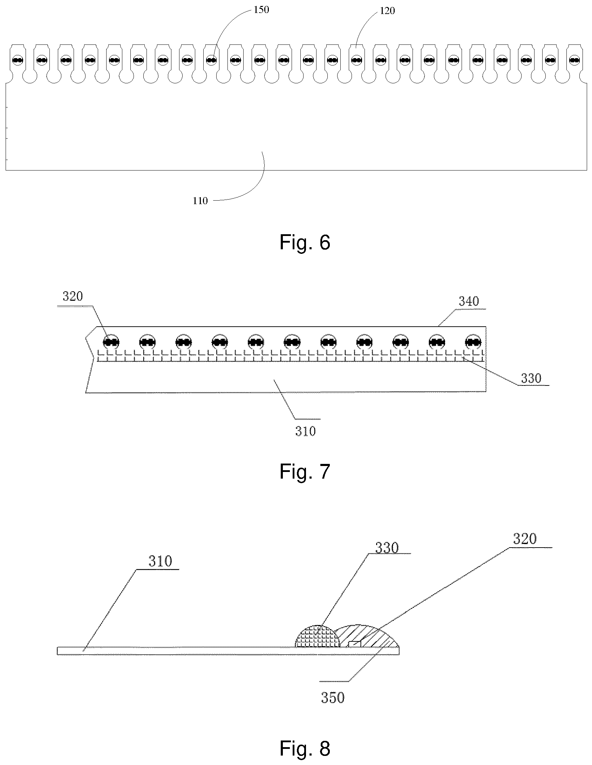

Referring to Fig. 6, an embodiment of the present disclosure also provides an LED light strip, which comprises an LED light strip substrate and LED flip chips 150 arranged on the peninsula regions 120.

It should be noted that the LED light strip substrate in this embodiment is provided as the same as that of the LED light strip substrate described in the foregoing embodiments, and will not be repeated here.

In the LED light strip provided by the embodiment of the present disclosure, individual LED flip chips 150 are arranged on the same side surfaces of peninsula regions 120. After the peninsula regions 120 are bent, the side surface of each of the peninsula regions 120 where the LED flip chip 150 is provided and a corresponding side surface of the body region 110 form a predetermined angle therebetween. Or, as shown in Fig. 2, preferably, the other side surface opposite to the side surface where the LED flip chip 150 is provided and a corresponding side surface of the body region 110 form a predetermined angle θ therebetween.

The LED light strip provided by the embodiment of the present disclosure can easily cause the light emitted by the LED flip chip 150 to be emitted from the sides of the LED light strip substrate. In addition, the overall LED light strip is light and small in volume, and is low in cost. When embedded in the terminal device, it can omit the adding of additional devices for guiding the light to the sides of the substrate. Therefore, it is suitable for the terminal devices having the small internal installation structure space and the bending region.

Referring again to Fig. 2, fluorescent glue 180 is optionally wrapped on the LED flip chip 150.

As for the LED light strip provided by the embodiment of the present disclosure, the fluorescent glue 180 can fulfill the effects of adjusting the color of emitted light of the LED flip chip 150 and protecting it. Furthermore, the fluorescent glue 180 can also function as a lens, which can increase the light output angle of the LED flip chip and increase the lateral light output rate of the light strip.

In the embodiment of the present disclosure, as shown in Figs. 4A and 4B, the fluorescent glue 180 wraps the LED flip chip 150, and the light-shielding reflection parts 160 are provided on two sides of the LED flip chip 150.

In the embodiments of the present disclosure, for the LED flip chips, LED flip chips of different colors can be used according to actual lighting requirements. Furthermore, a CSP packaged LED flip chip can also be used. The CSP package refers to a chip size package. The surface of the chip is coated with fluorescent glue, and the ratio of the area of the core chip to the area of the coated fluorescent glue is 1:1.1.

The embodiment of the present disclosure also provides a terminal device, which comprises the above-mentioned LED light strip.

It should be noted that the LED light strip included in the terminal device in this embodiment is provided as the same as the LED light strips described in the foregoing embodiments, and will not be repeated here.

In a terminal device, such as a light box, provided by an embodiment of the present disclosure, the LED light strip can be installed inside the device, near a side or a gap, or in a bent installation structure, to provide a light source for the screen. The terminal device obtains an improved light transmittance rate due to the use of such LED light strip, thereby achieving a better display effect, and obtaining improved device integration, thereby achieving a thinner and lighter body.

Referring to Figs. 7 and 8, the embodiment of the present disclosure also provides another LED side light-emitting light strip, including a substrate 310, a first surrounding dam 330 provided on the substrate 310, and a plurality of flip LED chips 320 (such flip LED chip is small in size and can be used under a large current and at the same time, it has strong heat dissipation and antistatic ability, which can increase the service life of the light strip).

Each flip LED chip 320 may be disposed at a position of a predetermined distance from the edge 340 of the substrate; and the first surrounding dam 330 may be disposed at a position closer to the inner side of the substrate 310, compared to the flip LED chips 320.

In order for the light emitted by the flip LED chip 320 on the substrate 310 to be emitted from the sides of the substrate 310, it is necessary to reduce the light output angle of light emitted upward from the front side of the substrate 310, so as to enhance the light output rate of the flip LED chip 320 which emits light at sides on the substrate 310, so as to achieve the side light emitting.

The flip LED chip 320 can be arranged along the edge 340 of the substrate, and the predetermined distance between the flip LED chip 320 and the edge of the substrate can be determined according to the width of the substrate 310, for example, it can be zero, or it can be between 1/8 and 1/3 of the width of substrate, in order to ensure that the flip LED chip 320 is closer to the edge 340 of the substrate, and meanwhile a suitable position (suitable space) is reserved between it and the edge 340 of the substrate, which is convenient for the subsequent packaging processing of the light strip without affecting the normal light emitting of the light strip.

As shown in Fig. 8, the first surrounding dam 330 is arranged at a position closer to the inner side of the substrate 310, compared to the flip LED chip 320, that is, it is arranged on the other side opposite to the side where the edge 340 of the substrate is located. The first surrounding dam 330 can be made of materials with light-shielding and reflective effects, such as surrounding dam glue, which therefore can shield and reflect the light emitted by the flip LED chip 320, so that the light emitted by the flip LED chip 320 can be concentrated into the specified range, and the lateral light output rate is effectively guaranteed.

The height of the first surrounding dam 330 can be larger than the height of the flip LED chip 320, and the lateral light output angle of the flip LED chip 320 can be adjusted by adjusting the height and shape of the first surrounding dam 330.

The LED side light-emitting light strip provided by the embodiment of the present disclosure can effectively make the light output direction of the flip LED chip 320 extend toward the sides of the substrate, which fulfills the effect of limiting the light output angle of the flip LED chip 320, and prevents occurrence of the situation that the emitted light spreads too much which reduces the lateral light output rate. At the same time, the overall LED side light-emitting light strip provided by the embodiments of the present disclosure is lighter and thinner, and the cost is lower, which can meet requirements which the terminal device with relatively small internal installation space, such as light boxes and counters, requests for the light source.

Referring to Fig. 8, in the embodiment of the present disclosure, the LED side light-emitting light strip may further comprise fluorescent glue 350 that wraps the flip LED chip 320.

After wrapping the fluorescent glue 350 on the flip LED chip 320, a first surrounding dam 330 may be provided on one side of the fluorescent glue 350.

In the LED side light-emitting light strip provided by the embodiment of the present disclosure, the fluorescent glue 350 wrapped on the flip LED chip 320 can be fluorescent silica gel mixed with a suitable proportion of fluorescent powders to protect the flip LED chip 320 and adjust the color of the emitted light.

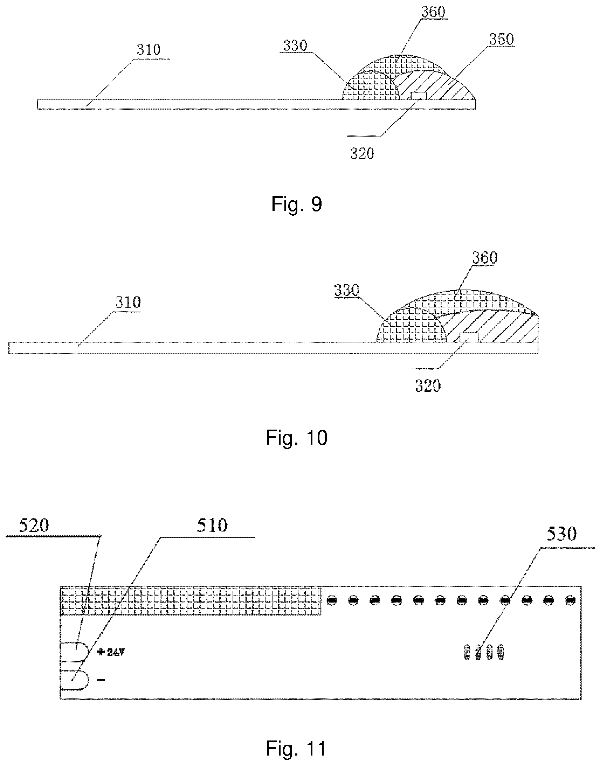

Referring to Fig. 9, in the embodiment of the present disclosure, the LED side light-emitting light strip may further comprise a second surrounding dam 360.

Optionally, the second surrounding dam 360 is disposed above the fluorescent glue 350, and the second surrounding dam 360 is connected to the first surrounding dam 130 on a side away from the edge of the substrate.

In order to be able to limit the lateral light output angle of the flip LED chip 320 so as to make the emitted light concentrated in the directions covered by the light output angle, a second surrounding dam 360 can be additionally provided, to reduce the light output face of the flip LED chip 320 from the front surface of the substrate 310 and facing upward, so as to increase its lateral light-emitting rate (luminous efficiency). For example, by adjusting the shapes and sizes of the first surrounding dam 330 and the second surrounding dam 360, etc., the lateral light output angle of the flip LED chip 320 can be adjusted.

In the LED side light-emitting light strip provided by the embodiment of the present disclosure, the first surrounding dam 330 and the second surrounding dam 360 can be connected with each other, so that side light-emitting light strips with different light output angles can be provided to the terminal device according to different internal installation structures. In addition, such a design can also increase the lateral light output rate and reduce the limitations caused by the small space, thereby meeting the different light-emitting requirements of the terminal device.

Referring to Fig. 10, the side of the second surrounding dam 360 provided by the embodiment of the present disclosure, close to the edge of the substrate, may also extend to a position flush with the edge of the substrate.

The LED side light-emitting light strip provided by the embodiment of the present disclosure adopts the first surrounding dam 330 and the second surrounding dam 360 that are connected with each other, and the second surrounding dam 360 extends to be flush with the edge of the substrate, which can prevent the occurrence of the situation of excessive light divergence and light leakage. The effect of side light emission is effectively enhanced, so that the light emitted by the flip LED chip 320 is concentrated and therefore emitted from one side of the substrate 310 more completely. The LED side light-emitting light strip provided by the embodiment of the present disclosure can provide a light source for terminal devices with a small internal installation space by way of side light emitting, which reduces light loss, improves light transmittance rate, and at the same time prevents regions, which do not need light radiation, from being interfered due to being exposed to light.

The thickness of the LED side light-emitting light strip provided by the embodiment of the present disclosure may be 1mm-5mm, particularly 1mm-3mm, such as 1mm, 2mm or 3mm, particularly 1.5mm. Such LED side light-emitting light strips can achieve the side light emitting effect while also making the thickness of the light strip lighter and thinner as a whole, so as to better meet the requirements of terminal device with a narrow internal installation space, such as, being easily embedded in the interior gap, saving the internal space.

In the prior art, since the main light source of the existing side light-emitting light strip is patch LED lamp beads, and the volume of the LED patch lamp beads is relatively large, and the requirement for the arrangement spacing is high, and therefore, generally speaking, the number of lamp beads that can be installed in the light strip per meter is between 60-180. In contrast, the LED side light-emitting light strip provided by the embodiments of the present disclosure use small-volume flip LED chips, and the spacing between adjacent flip LED chips can be 1mm-5mm, especially 1.5mm-2.2mm, such as 1.5mm, 1.8mm, 2mm or 2.2mm, such that it is possible to arrange them more densely on the substrate, and the number of flip LED chips that can be installed on the light strip per meter can reach, for example, 500, which significantly helps to achieve continuous luminous effect without light spot.

In the LED side light-emitting light strip provided by the embodiment of the present disclosure, the substrate may be a flexible substrate, which can adjust the installation position according to the structure of the installation space without being easy to break the light strip, thereby facilitating installation in a terminal device with a small and narrow space and a bending structure, to meet the lighting requirements of different terminal devices.

In the LED side light-emitting light strip provided by the embodiment of the present disclosure, the fluorescent glue can be continuously provided on each flip LED chip. This design facilitates quickly covering each flip LED chip on the substrate with fluorescent glue.

In the LED side light-emitting light strip provided by the embodiment of the present disclosure, the first surrounding dam and the second surrounding dam can be continuously coated respectively, so that the flip LED chip can emit light laterally and prevent occurrence of the phenomenon of excessive light diffusion and light leakage, which effectively reduces the area of the light emitted upwards from the front face of the substrate, and increases its lateral light output rate.

In the LED side light-emitting light strip provided by the embodiment of the present disclosure, the first surrounding dam and the second surrounding dam can be made of surrounding dam glue, and the main component of the surrounding dam glue can be silica gel with the effects of shading and reflecting light, but not only limited to silica gel, but may be any other material that can provide light-shielding and reflection effects.

Referring to Fig. 11, the LED side light-emitting light strip provided by the embodiment of the present disclosure may further comprise a positive electrode 520 and a negative electrode 510 of a power supply connected to the flip LED chips, and the value of the voltage of the power supply may be 24V, for example. In addition, the LED side light-emitting light strip may also comprise a current-limiting resistor 530.

In the LED side light-emitting light strip provided by the embodiment of the present disclosure, the substrate may further comprise a solid crystal region, which is correspondingly provided thereon with a flip LED chip. In the embodiment of the present disclosure, after the flip LED chip is placed in the solid crystal region, a fluorescent glue layer is coated on the flip LED chip, and then a first surrounding dam is provided on the other side opposite to the side of the flip LED chip close to the edge of the substrate (the first surrounding dam is disposed on one side of the fluorescent glue), and a second surrounding dam is provided above the fluorescent glue.

At present, most of the existing side light-emitting light strips are of the following three types.

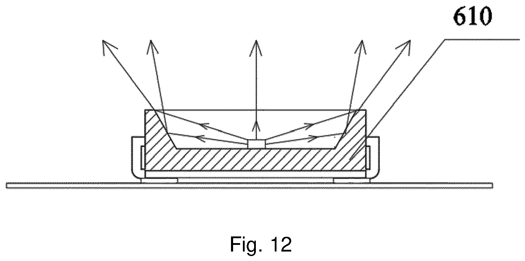

As for the first type, the light source is mainly embodied as the patch LED lamp beads, wherein the patch LED lamp beads are in the form of a bowl cup 610; the light emitting angle is generally about 120 degrees; as shown in Fig. 12, it has a certain volume and is difficult to be intensively mounted to realize the effect of continuous lighting without light spots.

As for the second type, it uses a silicone sleeve to wrap the conventional front side light-emitting light strip to achieve the side light emitting in appearance, and however, because the silicone sleeve needs to completely wrap the LED light strip, the cost is increased and the volume is too large, and since the surface silica gel blocks light, the actual light-emitting rate is low.

As for the third type, the light source is also embodied as the patch LED lamp beads, wherein in this kind of light strip, the surface of each patch LED lamp bead is provided with a lens with one side opening, and the light emitted from the front side of the LED is reflected by the lens so that it can be emitted from the side surfaces of the lens, so as to achieve the side light-emitting effect of the light strip, and the finished product has a large volume and a high cost, and the continuous light-emitting effect cannot be achieved.

Compared with the existing LED side light-emitting light strips, the LED side light-emitting light strip provided by the embodiments of the present disclosure can effectively make the light output direction of the flip LED chip extend from the sides of the substrate, which fulfills the effect of limiting the light output angle of the flip LED chip and prevents the emitted light from spreading too much. In addition, the overall LED side light-emitting light strip of the present disclosure is lighter and thinner, and the cost is lower, which can meet the requirements which terminal devices with a relatively small internal installation space request for the light source.

The embodiment of the present disclosure also provides a terminal device, which comprises the above-mentioned LED side light-emitting light strip.

It should be noted that the LED side light-emitting light strip included in the terminal device in this embodiment is provided as the same as the LED side light-emitting light strip of the foregoing embodiments, and will not be repeated here.

In a terminal device, such as a light box, provided by an embodiment of the present disclosure, the LED light strip can be installed inside the device, close a side or a gap, or located in a bent installation structure, to provide a light source for the screen. The terminal device obtains an improved light transmittance rate, due to the use of such LED light strips, thereby achieving a better display effect and obtaining an improved device integration, so as to achieve a thinner and lighter body. Those skilled in the art can understand that the drawings are only schematic diagrams of preferred implementation scenarios, and the modules or processes in the drawings are not necessarily necessary for implementing the embodiments of the present disclosure.

Those skilled in the art can understand that the modules in the device in the implementation scenario can be distributed in the device in the implementation scenario according to the description of the implementation scenario, or can be changed correspondingly to be located in one or more devices different from the implementation scenario. The modules of the above implementation scenarios can be combined into one module or further divided into plural sub-modules.

The above serial numbers of the present disclosure are only for description, and do not represent the pros and cons of the implementation scenarios. The above disclosure is only a few specific implementation scenarios of the present disclosure, but the present disclosure is not limited thereto, and any changes that can be thought of by those skilled in the art should fall within the protection scope of the present disclosure.

### Industrial Applicability

The LED light strip substrate provided by the embodiments of the present disclosure promotes the realization of an LED side light-emitting light strip with an overall volume light and small and the cost low; the LED side light-emitting light strip provided by the embodiments of the present disclosure can effectively make the light emitting direction of the flip LED chip laterally extend from the substrate, which fulfills the effect of limiting the light output angle of the flip LED chip, and is convenient to be bent and placed in the gap of the terminal device, which is conducive to achieving a more continuous side light-emitting effect while being not easy to be broken; moreover, the terminal device provided by the embodiments of the present disclosure obtains increased light transmittance rate due to the use of such LED side light-emitting light strips, thereby achieving better display effects, and obtaining improved device integration, so as to achieve a thinner and lighter body.

## Claims

1. An LED light strip substrate, comprising a body region and peninsula regions,
wherein the peninsula regions are spaced apart along an edge of the body region and the peninsula regions can be bent to form a predetermined angle with the body region, and the peninsula regions are each configured to be provided with an LED flip chip; and
the body region is provided with a circuit configured to connect the LED flip chips.

2. The LED light strip substrate according to claim 1, wherein each of the peninsula regions comprises a chip placement region and a bending region arranged between the body region and the chip placement region;
the chip placement region is configured to be provided with the LED flip chip; and
a width of the bending region is smaller than a width of the chip placement region.

3. The LED light strip substrate according to claim 2, wherein the width of the bending region, which is at a first section whose width is narrowest in a lateral direction, is smaller than the width of the chip placement region, which is at a second section whose width is narrowest in the lateral direction.

4. The LED light strip substrate according to claim 2, wherein a shape formed by an edge or part of the edge between two adjacent bending regions is a circular arc shape.

5. The LED light strip substrate according to claim 2, wherein in the chip placement region, two sides of the LED flip chip are each provided with a light-shielding reflection part configured for adjusting a light output angle of the LED flip chip; and
an extension direction of the light-shielding reflection part is perpendicular to an extension direction of the chip placement region.

6. The LED light strip substrate according to claim 1, wherein the predetermined angle is an angle of an included angle between the peninsula regions and the body region, and the predetermined angle is greater than 0 degrees and less than 180 degrees; and
a filling shaping part is provided between a side of the body region related to the included angle and a side of each of the peninsula regions related to the included angle, for supporting and fixing the peninsula regions and the body region; and
the filling shaping part is located on a side opposite to a surface side of each of the peninsula regions where the LED flip chip is provided.

7. The LED light strip substrate according to claim 1, wherein a spacing between adjacent peninsula regions in a lateral direction is 1mm-5mm, in particular, 1.8mm-2.5mm, and a length of each of the peninsula regions is 1.5mm-5mm along a longitudinal direction.

8. An LED light strip, wherein the LED light strip comprises the LED light strip substrate according to any one of claims 1-7 and LED flip chips provided on the peninsula regions of the LED light strip substrate.

9. The LED light strip according to claim 8, wherein a fluorescent glue is wrapped on the LED flip chip.

10. A terminal device, wherein the terminal device comprises the LED light strip according to claim 8 or 9.

11. An LED side light-emitting light strip, wherein the LED side light-emitting light strip comprises: a substrate, a first surrounding dam provided on the substrate, and a plurality of LED flip chips;
each of the LED flip chips is arranged at a position at a predetermined distance from an edge of the substrate; and compared with the LED flip chip, the first surrounding dam is arranged at a position closer to an inner side of the substrate.

12. The LED side light-emitting light strip according to claim 11, wherein the edge of the substrate is located on an outer side of the substrate opposite to the inner side of the substrate; or the inner side of the substrate is a side of the LED substrate where the LED flip chip is not provided.

13. The LED side light-emitting light strip according to claim 11, wherein the LED side light-emitting light strip further comprises a fluorescent glue wrapping the LED flip chip.

14. The LED side light-emitting light strip according to claim 13, wherein the LED side light-emitting light strip further comprises a second surrounding dam, and the second surrounding dam is at least partially disposed above the fluorescent glue.

15. The LED side light-emitting light strip according to claim 14, wherein the second surrounding dam is partially disposed above the fluorescent glue, and a side of the second surrounding dam away from the edge of the substrate is at least partially connected to the first surrounding dam.

16. The LED side light-emitting light strip according to claim 14 or 15, wherein a side of the second surrounding dam close to the edge of the substrate extends to be flush with the edge of the substrate.

17. The LED side light-emitting light strip according to claim 11, wherein a thickness of the LED side light-emitting light strip is 1mm-5mm, and especially 1mm-3mm.

18. The LED side light-emitting light strip according to claim 11, wherein a spacing between adjacent LED flip chips is 1mm-5mm, and especially 1.5mm-2.2mm.

19. The LED side light-emitting light strip according to claim 13, wherein the fluorescent glue is continuously provided on the substrate and covers each of the LED flip chips.

20. A terminal device, wherein the terminal device comprises the LED side light-emitting light strip according to any one of claims 11 to 19.
